Europäisches Patentamt

European Patent Office

Office européen des brevets

(11) Publication number: **0 045 822**
**B1**

(12) **EUROPEAN PATENT SPECIFICATION**

(45) Date of publication of patent specification: **29.05.85**

(21) Application number: **80200753.4**

(22) Date of filing: **08.08.80**

(51) Int. Cl.⁴: **C 23 C 14/34, H 01 J 37/34**

(54) **Cylindrical magnetron sputtering cathode.**

(43) Date of publication of application:
**17.02.82 Bulletin 82/07**

(45) Publication of the grant of the patent:
**29.05.85 Bulletin 85/22**

(84) Designated Contracting States:
**AT BE CH DE FR GB IT LI LU NL SE**

(56) References cited:
**DE-A-2 707 144**
**US-A-4 169 031**
**US-A-4 175 030**
**US-A-4 179 351**

(73) Proprietor: **BATTELLE DEVELOPMENT CORPORATION**
**505 King Avenue**
**Columbus Ohio 43201 (US)**

(72) Inventor: **Zega, Bogdan**
**67, rue de Lyon**
**CH-1203 Geneva (CH)**

(74) Representative: **Dousse, Blasco**
**7, route de Drize**
**CH-1227 Carouge/Genève (CH)**

Courier Press, Leamington Spa, England.

EP 0 045 822 B1

## Description

Field of the Invention

The present invention relates to a cylindrical magnetron sputtering cathode.

Background of the Invention

The recent development of magnetically-enhanced cathodic sputtering is presently providing a major contribution to the coating field, taking into account the much higher deposition rates thus obtainable with respect to those obtained with conventional sputtering, which render, therefore possible the production of coatings on an industrial scale for many applications.

The production of coatings by magnetically-enhanced cathodic sputtering is generally carried out, in function of the different envisaged coating applications, with sputtering systems assuming one of the two following main types of geometrical configurations, i.e. sputtering systems with planar configurations or sputtering systems with cylindrical configurations. From these two types of systems, only the second type with cylindrical configurations will be further considered in the present specification.

The first magnetically-enhanced sputtering systems to have been proposed with cylindrical configurations were systems of the Penning-type, designed for ensuring the application, inside the annular interspace extending between a central cylindrical sputtering target and the substrates to be coated disposed concentrically around said central target of an axial uniform magnetic field generated from the outside (thanks to the providing of a Helmholtz-type coil disposed concentrically outside the vacuum bell jar). The sputtering rates obtainable with these systems of Penning-type are indeed increased with respect to those obtained with conventional sputtering systems, but not in a decisive manner, taking into account the uniformity of the thus applied axial magnetic field which causes a simple intensification, but without confinement, of the discharge plasma. Such systems of the Penning-type are furthermore limited to the coating of substrates made of non-magnetic materials (so as not to shield the magnetic field generated from the outside).

The magnetically-enhanced sputtering systems to be now generally proposed with cylindrical configurations are the so-called "cylindrical magnetron sputtering" systems such as proposed by U. Heisig et al. (cf. Paper "High Rate Sputtering with a Torus Plasmaton" from U. Heisig, K. Goedicke and S. Schiller — presented on 7th Int. Conf. on Electron and Ion Beam Science and Technology, Washington, D.C., USA, May 1976) or by N. Kuriyama (cf. German patent application No. 2.655.942 in the name of K. K. Tokuda Seisakusho). These "cylindrical magnetron sputtering" systems are designed for ensuring the application, over the sputtering face of a tubular target, of magnetic fields shaped in such a manner so to have their flux lines forming a plurality of equiaxially spaced closed-loop toroidal arches circumferentially extending over said sputtering face, thanks to the providing of a specific magnetron constituted by a plurality of axially spaced ring magnets circumferentially extending against the back face of said target. The providing of such a magnetron for generating axially spaced magnetic toroidal arches over the sputtering face of the tubular target offers the major advantage, by causing the formation of a plurality of intense ring plasmas confined within these toroidal arches, of giving rise to very high sputtering rates of the tubular target. The particular design of such a magnetron is however not without raising some problems as regards the proper target cooling, as well as the uniformity of the target sputtering and/or the substrate coating, especially when it becomes necessary of using targets of relatively great length (in view for instance of enabling the coating of long substrates). The proper cooling of the tubular target, which is rendered absolutely necessary because of its excessive heating due to intense sputtering, as a matter of fact cannot be ensured with total security in such a magnetron, taking into account the particular arrangement of the axially spaced ring magnets with respect to the tubular target, which put a severe restraint on the axial circulation of the liquid coolant along the back face of the tubular target (notwithstanding the fact that with such magnetron the liquid coolant generally cannot contact the annular regions of the back face of the target at the level of which the ring plasmas are confined, i.e. the annular regions at the level of which the sputtering, and thus, the heating up is the more intense). The obtention, with such a magnetron, of a perfectly uniform target sputtering and/or substrate coating appears besides very unreliable (in spite of the to-and-fro axial moving of the magnetron with respect to the tubular target recommended in such a case for improving the uniformity), taking into account the very unstable nature of the separate ring plasmas likely to be sustained by such a magnetron. It is as a matter of fact known that the current-voltage characteristic of magnetrons flattens for high currents, which in other terms means that the plasma impedance decreases with increasing current. The design of a magnetron intended to sustain a plurality of separate confined plasmas therefore constitutes a design very sensitive to the occurrence of any dissymetry (whether concerning the geometrical parameters of the different magnets constitutive of the magnetron, or the strength of the magnetic field generated by these different magnets, or any other type of dissymetry, such as for instance that able to occur during the to-and-fro axial moving of the magnetron with respect to the tubular target), taking into account that such separate plasmas behave as electrical circuit elements put in parallel. The occurrence of any dissymetry would as a matter of fact result in a current desequilibrium between the separate plasmas behaving as electrical elements put in parallel, which desequilibrium could only worsen with time because of the plasma impedance decrease with increasing current, whereby likely to definitively endanger the uniformity of target sputtering and/or substrate coating (the to-and-fro axial moving of the magnetron with respect to the tubular target being totally unable to restore such uniformity along the whole length of this target).

In the German Patent application No. 2.707.144 (in the name of Sloan Technology Corp.) is furthermore described (cf. Figs. 18 and 19 of that application) a cylindrical magnetron sputtering system which is designed for generating over the sputtering face of a tubular target a simple closed-path magnetic tunnel, which axially extends along the full length of the tubular target while circumferentially extending only along a small region of this tubular target (such single closed-path magnetic tunnel being generated thanks to the providing, behind the back face of the tubular target, of a magnet arrangement having an extension similar to that of the magnetic tunnel to be generated). Such a magnetron sputtering system however requires the complete rotation of the magnet arrangement by at least one turn, so as to ensure the uniform sputtering of the whole target (not taking into account the lower sputtering rates likely to be obtained because of this required complete rotation). No precision is besides given concerning the target cooling.

Outline of the Invention

The present invention has precisely the object of remedying the aforementioned drawbacks, in proposing a cylindrical magnetron sputtering cathode according to claim 1.

It may thus be seen that one of the essential features of the present invention lies in the providing, behind the back face of a tubular target, of a specific magnetron consisting of a plurality of equiangularly spaced axially extending radially magnetized magnets, which is designed for generating, over the sputtering face of said target, magnetic fields shaped in such a manner as to form a plurality of equiangularly spaced axially extending straight arch portions connected to each other by arcuate arch end-portions, so as to define one closed-loop arch over said sputtering face. Such a design offers the major advantage of ensuring an excellent target cooling whatever the target length, since the liquid coolant can in such a case be freely circulated along the longitudinal spaces delimitated between adjacent magnets of said plurality, i.e. against the longitudinal regions of the tubular target where the sputtering, and thus the heating up, is the more intense.

Brief Description of the Drawings

The accompanying drawings are diagrammatic illustrations by way of example of several embodiments of the cylindrical magnetron sputtering system according to the present invention.

Fig. 1 is a diagrammatic sectional view of a first embodiment.

Fig. 2 is a perspective view of an element constitutive of the cathode of this first embodiment, drawn to a larger scale.

Fig. 3 is a cross-sectional view according to line III—III of Fig. 2.

Fig. 4 is a perspective view similar to that of Fig. 2, showing the outside of said cathode.

Fig. 5 is a diagram explicative of the functioning of the above embodiment and variation.

Fig. 6 is a diagrammatic sectional view similar to that of Fig. 1, illustrating a second embodiment.

Fig. 7 is a cross-sectional view according to line IX—IX of Fig. 6.

Fig. 8 is a view, developped in the plane, of a particular element of Figs. 6 and 7.

Specific Description

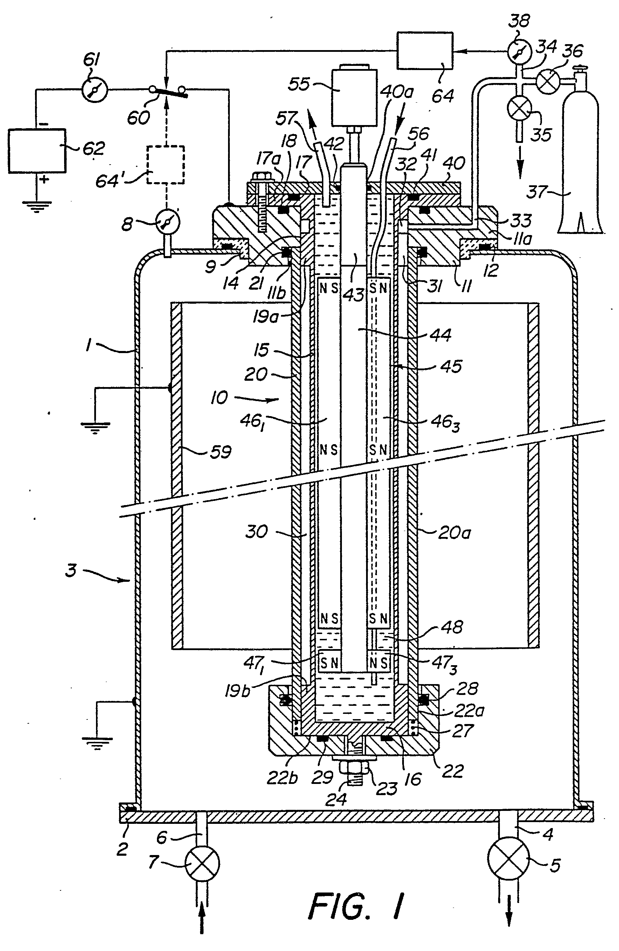

The Figures 1 to 4 relate to a first embodiment of the apparatus of the present invention, according to which there is made use of a cylindrical magnetron sputtering cathode extending centrally inside said apparatus, so as to enable the coating of substrates disposed concentrically around said cylindrical cathode.

This first embodiment of Figs. 1 to 4 comprises (Fig. 1) a bell jar 1 resting on a base plate 2, so as to form a sealed enclosure 3. The base plate 2 is provided with an evacuation port 4 connected (via a valve 5) to a suitable pumping device (not shown), and with an admission port 6 connected by a gauged valve 7 to a source of an appropriate gas such as argon (not shown). The bell jar 1 is further provided with a pressure gauge 8.

Through a central circular opening 9 provided in the top of the bell jar 1 is introduced a cylindrical magnetron sputtering cathode 10, which extends centrally inside the sealed enclosure 3. This cylindrical cathode 10 comprises at its upper end a discoidal metal block 11, which rests by means of an external flange 11a on the border of the opening 9, via an insulating ring 12. The discoidal metal block 11 is in turn provided with a central circular opening 14, through which is introduced a tubular sheath 15 with a flat bottom 16 and an open top 17, which rests by means of a top external flange 17a against the upper plane face of the block 11 (tightness between the flange 17a and the block 11 ensured by an O-ring 18). The tubular sheath 15, which is made of a high thermally-conducting material such as copper, is further provided at both lateral ends with respective external annular shoulders 19a and 19b of low thickness, dimensioned for closely fitting the internal diameter of the central opening 14 of the block 11.

Around the tubular sheath 15 is in turn coaxially mounted an open-ended tubular target 20 made of a material to be sputtered, internally dimensioned for closely fitting the respective end-shoulders 19a and 19b of the tubular sheath 15. The upper end of the tubular target 20 protrudes inside an annular recess 11b provided in the lower part of the block 11 for enlarging the corresponding lower part of the opening 14, so that this upper end of target 20 is firmly inserted between the lateral wall of the recess 11b and the shoulder 19a of the tubular sheath 15 (tightness between the target 20 and the block 11 ensured by an O-ring 21 disposed in an annular groove provided in the lateral wall of recess 11b). The lower end of the tubular target 20, which rests by its internal wall against the end-shoulder 19b of sheath 15, is in turn closely surrounded by the lateral wall 22a of a cup-shaped closing element 22, the bottom 22b of which is maintained in close contact against the bottom 16 of the sheath 15 by means of a nut 23 cooperating with a screw 24 integral with the bottom 16 (screw 24 protruding below the bottom 22b through a central hole provided in said bottom 22b). In the annular space between the shoulder 19b of the sheath 15 and the lateral wall 22a of the closing element 22 is besides mounted an annular spring 27, compressed between the bottom 22b of closing element 22 and the lower end of the target 20 so as to keep the upper end of said target 20 tightly inserted inside the recess 11b of the block 11, whatever the thermal dilatation likely to be incurred by said target 20 (the tightness between the lower end of target 20 and the lateral wall 22a of closing element 22 being ensured by an O-ring 28 disposed in an annular groove provided in the lateral wall 22a, while the tightness between the respective bottoms 16 and 22b is ensured by an O-ring 29 disposed in an annular groove provided in the upper face of bottom 22b).

The thus coaxially mounted tubular sheath 15 and tubular target 20 therefore delimitate an annular tight chamber 30 of low thickness therebetween, which axially extends from the top metal block 11 to the bottom closing element 22 of the sputtering cathode 10 (the tightness of said chamber 30 being ensured by the respective O-rings 18, 21, 28 and 29). The tubular sheath 15 and tubular target 20 are dimensioned with respect to each other (adequate choice of the internal diameter of the target 20 with respect to the external diameter of sheath 15 and the thickness of the shoulders 19) so as to delimitate an annular chamber 30 presenting an internal thickness preferably comprised between 0.1 and 0.3 mm (thickness strongly exaggerated with respect to the other dimensions on the drawing, for purposes of better understanding).

This annular tight chamber 30 is besides connected to the outside of the sealed enclosure 3 thanks to the providing, in the upper end-shoulder 19a of the sheath 15, of a plurality of equiangularly spaced axially extending channels 31 emerging in an annular groove 32, which annular groove 32 in turn freely communicates with the outside by means of conduit 33 adequately pierced through the block 11. The outside emerging end of the conduit 33 is in turn connected to the first branch of a four-branch junction 34, the second branch of which is connected via a valve 35 to a suitable pumping device (not shown), the third branch of which is connected via a gauged valve 36 to a source 37 of a high thermally-conducting gas (such as helium), and the fourth branch of which is connected to a pressure gauge 38.

The open top 17 of the tubular sheath 15 is closed by a plane cover 40 resting on the upper plane face of the flange 17a (the tightness between the cover 40 and the flange 17a being ensured by an O-ring 41 disposed in an annular groove provided in the upper face of said flange 17a). Through a central circular opening 40a provided in the cover 40 is inserted a cylindrical stud 43 (the tightness between the cover 40 and the stud 43 being ensured by an adequate O-ring 42), to the lower end of which is connected a soft iron rod 44 with a square cross-section, which centrally extends inside the tubular sheath 15 substantially along the whole length of the annular chamber 30.

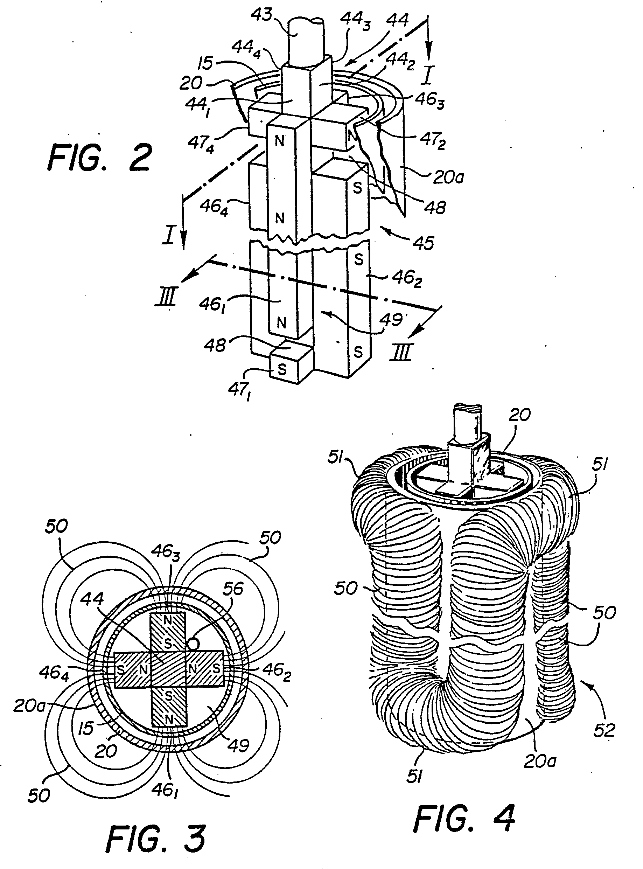

Around this soft iron central rod 44 is mounted a magnet assembly 45, designed for generating magnetic fields having flux lines which project in a curve from the outer sputtering face 20a of the tubular target 20 and return thereto to form arch portions thereover (flux lines successively traversing the tubular sheath 15 and the tubular target 20 made of non-magnetic materials). This magnet assembly 45, which is better shown on the perspective view of Fig. 2 (magnet assembly 45 shown in Fig. 1 in a sectional view according to line I—I of Fig. 2), consists of a plurality of equiangularly spaced axially extending radially magnetized magnets $46_1$ to $46_4$ and $47_1$ to $47_4$, which are arranged against the four longitudinal faces of the central rod 44 in the following manner:

— parallelepipedic magnets $46_1$ and $46_3$, coupled by their south pole faces against the respective opposite faces $44_1$ and $44_3$ of the central rod 44 so as to have their north pole faces pointing in the vicinity of the inner wall of the tubular sheath 15, said parallelepipedic magnets $46_1$ and $46_3$ extending along the central rod 44 from its upper end portion to an intermediate portion situated immediately upward its lower end portion,

— parallelepipedic magnets $46_2$ and $46_4$, coupled by their north pole faces against the respective opposite faces $44_2$ and $44_4$ of the central rod 44 so as to have their south pole faces pointing in the vicinity of the inner wall of the tubular sheath 15, said parallelepipedic magnets $46_2$ and $46_4$ extending along the central rod 44 from its lower end portion to an intermediate portion situated immediately below its upper end portion,

— cubic end-magnets $47_1$ and $47_3$, coupled against the lower end portion of the respective opposing faces $44_1$ and $44_3$ of the central rod 44 so as to extend in the prolongation of the corresponding parallelepipedic magnets $46_1$ and $46_3$ while being separated from the latter by gaps 48, said cubic end-magnets $47_1$ and $47_3$ being coupled by their north pole faces against the lower end portions of said opposing faces $44_1$ and $44_3$ so as to have their south pole faces pointing in the vicinity of the inner wall of the tubular sheath 15, and,

— cubic end-magnets $47_2$ and $47_4$, coupled against the upper end portion of the respective opposing faces $44_2$ and $44_4$ of the central rod 44 so as to extend in the prolongation of the corresponding parallelepipedic magnets $46_2$ and $46_4$ while being separated from the latter by gaps 48, said cubic end-magnets $47_2$ and $47_4$ being coupled by their south pole faces against the upper end portions of said opposing faces $44_2$ and $44_4$ so as to have their north pole faces pointing in the vicinity of the inner wall of the tubular sheath 15.

The above-described plurality of magnets $46_1$ to $46_4$ and $47_1$ to $47_4$ constitutive of the magnet assembly 45 inserted inside the tubular sheath 15 is therefore arranged in such a manner as to generate flux lines which form over the outer sputtering face 20a of the tubular target 20 (Figs. 3 and 4) four equiangularly spaced axially extending straight arch portions 50 alternately connected to one another by four arcuate arch end-portions 51, whereby defining a single closed-loop arch 52 extending in a meandering manner over the entire circumference of the sputtering face 20a of said tubular target 20.

The upper end of the cylindrical stud 43 protruding outside the cover 40 is besides connected (Fig. 1) to the shaft of a motor 55, designed for slowly rotating the magnet assemble 45 according to a to-and-fro rotary movement, of an amplitude sufficient (about ±45°) for enabling the single closed-loop arch 52 generated by said magnet assembly 45 to be periodically scanned over the entire surface of the sputtering face 20a.

The closed tubular sheath 15 containing the magnet assembly 45 is furthermore provided with a circuit for circulating a liquid coolant such as cold water therewithin. This circuit comprises at least one admission conduit 56 extending from the outside of the cover 40 to near the bottom 16 of the sheath 15 (while traversing the magnet assembly 45 by extending along the corner of one of the longitudinal spaces 49 delimitated between the equiangularly spaced magnets 46 and 47), so as to bring the liquid coolant down to the bottom 16 of said sheath 15 (outside protruding end of the conduit 56 connected to a suitable liquid coolant source not shown on the drawing). The liquid coolant thus brought down to the bottom 16 can then freely flow upwards, by circulating along the free longitudinal spaces 49 delimitated between the equiangularly spaced different magnets 46 and 47, before being evacuated through an evacuating port 57 provided in the cover 40.

Inside the sealed enclosure 3 is finally disposed a tubular metal substrate 59 to be internally coated, arranged coaxially around the tubular target 20 of the central cylindrical cathode 10. The tubular metal substrate 59 is connected to ground (as well as the metal enclosure 3), while the central cathode 10 is connected via a switch 60 and an amperemeter 61 to the negative pole of a high-voltage source 62 whose other pole is also grounded.

The above apparatus finally comprises a control circuit 64, respectively connected by its input to the pressure gauge 38 and by its output to the switch 60. This control circuit 64 is designed for triggering the opening of the switch 60, as soon as the pressure recorded by the gauge 38 undergoes a sudden decrease with respect to a predetermined value.

The above-described sputtering apparatus operates in the following manner:

The cylindrical cathode 10 being provided with a new unconsumed target 20, the sealed enclosure 3 is evacuated and an argon atmosphere of the order of $10^{-4}$ to $10^{-2}$ torr (of the order $10^{-2}$ to 1 Pa) is introduced therein. Concurrently, the annular chamber 30 of the cathode 10 is also evacuated (by pumping means connected to the valve 35) and an helium atmosphere of the order of 10 torr (of the order of $10^3$ Pa) is introduced therein (by means of the gauged valve 36 connected to the helium source 37).

The liquid coolant being then circulated inside the tubular sheath 15 of the cathode 10, the switch 60 is closed, whereby causing the application of a negative high voltage to said cathode 10.

The negative biasing of the cathode 10 then produces in a known manner a glow discharge in the neighborhood thereof, which causes ionization of the argon atoms. The argon ions thus formed then bombard the sputtering face 20a of the tubular target 20, whereby causing the ejection (or sputtering) of atoms from said sputtering face 20a, which sputtered atoms are then deposited by condensation on the internal face of the tubular substrate 59.

The presence of the magnet assembly 45 inside the cylindrical cathode 10 has for effect of confining the discharge plasma (ionization region) within the closed-loop endless arch 52 formed over the sputtering face 20a by the flux lines of said magnet assembly 45, while concurrently producing a very high intensification of this discharge plasma. The formation of such an intense and confined discharge plasma may be explained in a known manner by the fact that the closed loop endless arch 52 generated by the magnet assembly 45 acts, with respect to the secondary electrons emitted by the target 20, as a trapping means which compels these secondary electrons to circulate along an extended continuous path around the sputtering surface 20a instead of directly migrating towards the anode, whereby drastically increasing the probability of ionizing collisions with argon atoms. The production of such an intense and confined discharge plasma therefore results in an intense ion bombarding of the sputtering face 20a of the target 20 (large ion current bombarding of the cathode), whereby causing an intense sputtering of said target 20, and thus the coating with a high deposition rate of the internal face of the tubular substrate 59.

The intense ion bombardment to which the target 20 is thus submitted however causes a high power dissipation at the target, whereby requiring a sufficient target cooling throughout the sputtering in view of preventing any damaging risk (possible deterioration of the target 20, and/or too high radiative heating of the substrate 59, and/or possible demagnetization of the magnet assembly 45). Such a sufficient target cooling throughout the sputtering is precisely ensured by the double cooling system provided in the present apparatus, i.e. the closed tubular sheath 15 containing the magnet assembly 45, which is provided with a liquid coolant circuit, and the annular chamber 30 of low thickness coaxially extending between this tubular sheath 15 and the back of the target 20, which is provided with an atmosphere of a high thermally conducting gas such as helium. The interposition of a stagnant helium layer of low thickness between the target 20 and the sheath 15 as a matter of fact authorizes, in spite of the higher power dissipation at the target, a permanent heat transfer from the target 20 to the sheath 15 (through said helium layer) which is proved to be sufficiently high for keeping the temperature of said target 20 down to maximum permissible values of the order of 500°C, provided that the temperature of said sheath 15 is for its part kept about the ambient value. The maintaining of the sheath 15 about the ambient value is precisely ensured by the liquid coolant circulated inside the sheath 15, which continuously evacuates towards the outside the heat continuously transferred through the helium gas layer of low thickness. The evacuation of such heat towards the outside is precisely all the better as the liquid coolant can freely circulate along the longitudinal spaces 49 delimitated between the equiangularly spaced different magnets 46 and 47, i.e. along longitudinal spaces 49 which precisely extend in front of the regions of the target 20 where the sputtering (and thus the power dissipation) is the more intense.

As the sputtering proceeds, the target 20 undergoes a progressive erosion, which would in principle remain localised in the only regions of the target covered by the closed-loop confined discharge plasma (i.e. in the regions covered by the closed-loop arch 52 formed by the flux lines of the magnet assembly 45). The providing of the motor 55 for slowly rotating the magnet assembly 45 according to an oscillatory rotatory movement with respect to the target 20 has however precisely for object of ensuring a uniform erosion of said target 20 (whereby resulting in an improved target life), by periodically scanning the closed-loop arch 52 (and thus the intense discharge plasma confined inside said arch 52) over the entire surface of the sputtering face 20a. The uniformity of the target erosion is furthermore all the better as there is produced a single closed-loop plasma meandering over the entire circumference of the sputtering face, whereby resulting in a practically uniform plasma current along its whole path. The above providing of the motor 55 for slowly rotating the magnet assembly 45 in turn results in a similar oscillatory rotational movement of said magnet assembly 45 with respect to the substrate 59, whereby giving rise to an excellent uniformity as regards the internal coating of the substrate 59.

When the substrate 59 is provided with a uniform coating of desired thickness, the sputtering operation is temporarily stopped so as to enable the replacement of said coated substrate by a new uncoated one, and the sputtering operation can then be immediately restarted. Throughout the successive coating of different substrates, the sputtering target 20 continues to be progressively eroded, whereby giving rise to its piercing at certain unforeseeable moment of the sputtering operation. Such a piercing is however proved to be totally harmful for the sputtering apparats and/or the substrates being coated, since it results in a simple irruption of helium inside the sealed enclosure 3, which is at once detected by the pressure gauge 38 (gauge 38 detecting a sudden decrease of helium pressure inside the annular chamber 30) for immediately controlling, by means of the controlling circuit 64, the automatic cut-off of the switch 60 of the sputtering apparatus. The pierced target 20, the consumption (and thus the lifetime) of which has been therefore optimized, can then be immediately removed from the sealed enclosure for being replaced by a new fresh one, and the sputtering operation can then be restarted for continuing the substrate coating.

In the above-described operation, the coating of each substrate 59 may besides, if desired, be preceded by a cleaning step, which cleaning step may be carried out in a known manner by negatively biasing said substrate 59 while the cylindrical cathode 10 is grounded (said biasing, which is the reverse of that applied during the coating, giving rise in a known manner to the generation of a glow discharge causing the proper sputtering of said substrate).

According to a variation of the above-described embodiment, the motor 55 for moving the magnet assembly 45 may be designed for rotating this assembly 45 according to an unidirectional rotatory movement instead of the to-and-fro rotatory movement previously described (the admission conduit 56 extending along one of the channels 49 of the magnet assembly 45 being in such a case advantageously replaced by a borehole, pierced through the stud 43 and the rod 44 so as to axially extend from the upper end of said stud 43 to the lower end of said rod 44), so as to cause full revolutions of the magnet assembly 45 with respect to the tubular target 20 and the substrate 59, whereby resulting in an effect similar to that previously described as regards the good uniformity of target sputtering as well as that of substrate coating.

According to another variation of the above-described embodiment, one may envisage to slightly modify the "mounting" design of the tubular target 20 and of the substrate 59, so as to rotate both the target 20 and the substrate 59 with respect to the magnet assembly 45, whereby resulting in effects similar to that previously described as regards the uniformity of target sputtering and substrate coating.

## Example

The sputtering apparatus of Figs. 1 to 4 is used for depositing a stainless steel coating of about 10 µm thick (for corrosion protection purposes) on the internal surface of soft iron tubes having a length of the order of 400 mm as well as an internal diameter of the order of 70 mm.

For such a deposition, the sputtering apparatus of Figs. 1 to 4 makes use of a cylindrical cathode 10 presenting the following structural parameters:

— tubular sheath 15 made of copper, presenting an external diameter of the order of 31.6 mm,

— tubular target 20 made of 18/8 stainless steel (stainless steel 304 according to US designation), presenting an internal diameter of the order of 32 mm (tubular sheath 15 and tubular target 20 therefore delimitating therebetween an annular chamber 30 having a thickness of the order of 0.2 mm), which tubular target 20 furthermore presents an initial thickness of the order of 1.5 mm, as well as an overall length of the order of 500 mm (tightness at both ends ensured by O-rings 21 and 28 made of Viton),

— magnet assembly 45 designed so as to generate in the vicinity of the sputtering face 20a of the target 20 magnetic fields having a strength of the order of 300 to 800 Ørsteds (depending on the actual erosion level of the target), said magnet assembly 45 being furthermore arranged inside the target 20 so as to cause the erosion of the latter along a length of about 450 mm.

A soft iron tube 59 to be coated having been arranged concentrically around the cylindrical cathode 10, the sealed enclosure 3 is evacuated to a pressure of about $1.10^{-3}$ Pa (via the valve 5), simultaneously with the chamber 20 (via the valve 35). The evacuating operation once terminated, the valve 35 is closed, and an atmosphere of helium up to a pressure of the order of 10 mbar is introduced inside the chamber 20 (via the gauged valve 36), while an atmosphere of argon up to a pressure of the order of 2 Pa is simultaneously provided inside the main enclosure 3 (via the valve 7).

The soft iron tube 59 is then submitted to a short cleaning prior to its coating, by biasing the iron tube 59 to a value of the order of −500 to −1000 volts while the magnetron cathode 10 is grounded (the glow discharge thus appearing between the tube and the magnetron cathode being maintained during about 5 min., so as to cause a sputtering of the internal surface of said tube which is sufficient for properly cleaning it).

The above cleaning once terminated (by switching off the above biasing), the pressure of argon inside the main enclosure 3 is decreased up to a value of the order of $4.10^{-1}$ Pa, in view of operating the coating proper of the tube 59. For that purpose, the tube 59 is grounded, while the magnetron cathode 10 is connected via the switch 60 (as shown on the drawing) to the negative pole of a DC power supply 62 delivering up to 12 Amps at about 500 Volts (the power supply 62 being besides protected against arcing by a current limiter). The deposition rate onto the internal surface of the tube is about 6 µm per kWh consumed, while the corresponding target erosion rate is about 12 µm per kWh consumed. Using a power of 6kW, the desired coating of about 10 µm thick onto the internal surface of the tube is therefore deposited in about 17 min. Under the above conditions, the maximum temperature reached by the target is of about 500°C in the sputtering zone, while not exceeding 200°C at both ends (i.e. in the vicinity of the O-rings 21 and 28).

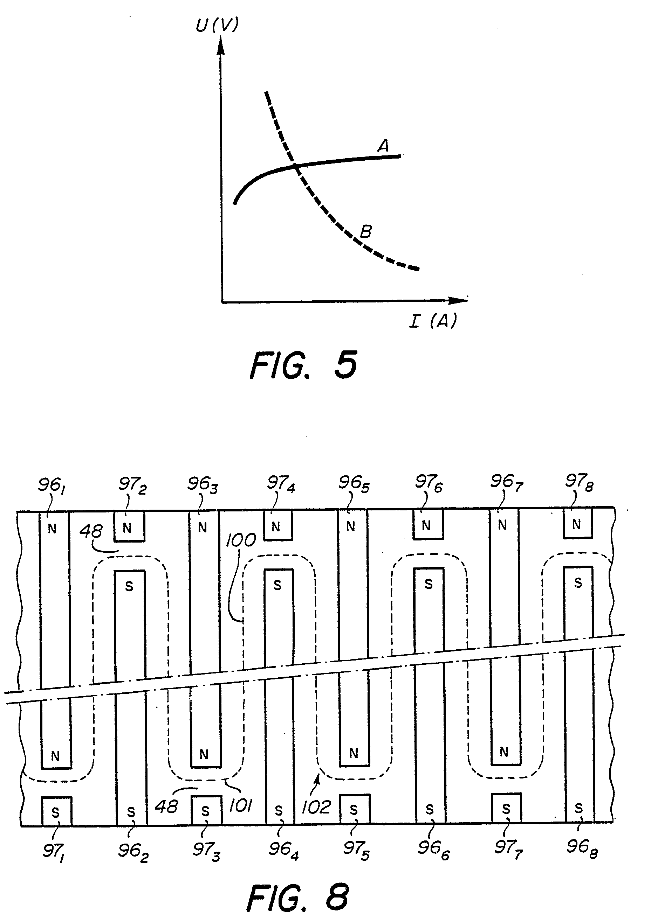

The diagram of Fig. 5 enables to better understand the question of plasma stability in the respective cases of a single meandering plasma or a plurality of separate plasmas. This diagram as a matter of fact illustrates a typical voltage-current characteristic related to magnetron sputtering apparatus (curve A in continuous line) which is known for flattening at high currents (mainly for low gas pressures for which the efficiency is the best), which in other terms means that the plasma impedance decreases with increasing current (cf. curve B in dotted lines). The generation of a plurality of separate plasmas behaving as electrical elements put in parallel therefore constitutes a design very unstable by nature, since any current desequilibrium likely to arise between separate plasmas because of the occurrence of an eventual dissymetry can only worsen with time because of the plasma impedance decrease with current increase. Such a desequilibrium on the other hand cannot develop in the case of a single meandering plasma (whatever the complexity of its path), since the different branches of such a single meandering plasma, by behaving as electrical elements put in series can only contribute to produce a relatively uniform plasma current (trapped electrons meandering along the whole path of said single plasma), whereby ensuring an excellent stability of such a single meandering plasma.

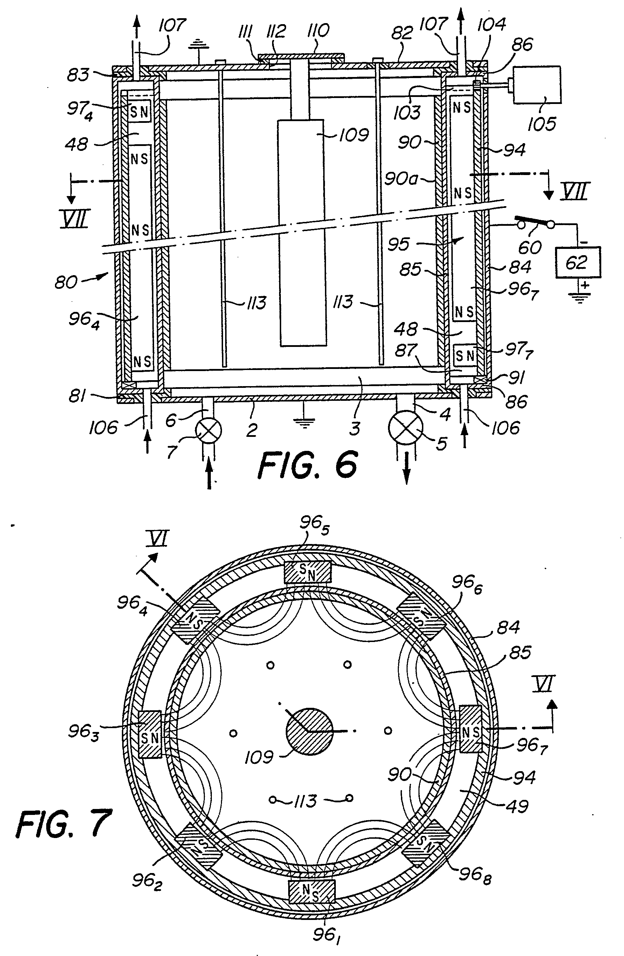

The Figs. 6 to 8 relate to a second embodiment of the apparatus of the present invention, according to which there is made use of a hollow cylindrical magnetron sputtering cathode disposed concentrically around the axis of the apparatus, so as to enable the external coating of substrates centrally extending along said axis (the elements of said embodiment of Figs. 6 to 8 which are unchanged with respect to those of Figs. 1 to 4 remaining allocated with the same figures of reference on the drawing).

This embodiment of Figs. 6 to 8 comprises (Fig. 6) a hollow cylindrical magnetron sputtering cathode 80 resting (via an insulating ring 81) on a baseplate 2, so as to form, in cooperation with a plane cover 82 closing (via an insulating ring 83) the open top of said hollow cylindrical cathode 80, a sealed enclosure 3 (said enclosure 3 further comprising an evacuation port 4 and an admission port 6 provided in the baseplate 2).

The hollow cylindrical cathode 80 more specifically comprises two concentric tubular walls 84 and 85, connected at both ends by end-walls 86 so as to delimitate in combination an annular tight chamber 87. Against the external face of the inner wall 85 is mounted a tubular target 90 made of material to be sputtered. Inside the annular tight chamber 87 is besides rotatively mounted a tubular support 94 made of soft iron (dimensioned so as to closely extend against the internal face of the outer wall 84), which rests against the bottom of the chamber 87 by means of an annular ball-bearing 91.

Against the inner face of the tubular support 94 is mounted a magnet assembly 95, which consists of a plurality of axially extending radially magnetized magnets $96_1$ to $96_8$ and $97_1$ to $97_8$, equiangularly spaced against the support 94 in the following manner (Figs. 7 and 8):

— parallelepipedic magnets $96_1$, $96_3$, $96_5$ and $96_7$, equiangularly spaced by 90° from one another around the tubular support 94, and coupled by their south pole faces against said support 94 so as to have their north pole faces pointing in the vicinity of the internal face of the tubular wall 85, said parallelepipedic magnets extending along the support 94 from its upper end portion to an intermediate portion situated immediately upward its lower end portion,

— parallelepipedic magnets $96_2$, $96_4$, $96_6$ and $96_8$, equiangularly spaced by 90° from one another around the tubular support 94 (while being equiangularly spaced by 45° from the corresponding magnets $96_1$, $96_3$, $96_5$ and $96_7$), and coupled by their north pole faces against said support 94 so as to have their south pole faces pointing in the vicinity of the internal face of the tubular wall 85, said parallelepipedic magnets extending along the support 94 from its lower end portion to an intermediate portion situated immediately below its upper end portion,

— cubic end-magnets $97_1$, $97_3$, $97_5$ and $97_7$ coupled against lower end portions of the tubular support 94, so as to extend in the prolongation of the corresponding parallelepipedic magnets $96_1$, $96_3$, $96_5$ and $96_7$ while being separated from the latter by gaps 48, said cubic end-magnets being coupled by their north pole faces against the tubular support 94 so as to have their south pole faces pointing in the vicinity of the internal face of the tubular wall 85, and,

— cubic end-magnets $97_2$, $97_4$, $97_6$ and $97_8$ coupled against upper end portions of the tubular support 94, so as to extend in the prolongation of the corresponding parallelepipedic magnets $96_2$, $96_4$, $96_6$ and $96_8$, said cubic end-magnets being coupled by their south pole faces against the support 94 so as to have their north pole faces pointing in the vicinity of the internal face of the tubular wall 85.

The above-described magnet assembly 95 mounted inside the tight chamber 87 is therefore arranged in such a manner as to generate flux lines which form over the inner sputtering face 90a of the tubular target 90 eight equiangularly spaced axially extending straight arch portions 100 (schematized in dotted lines on the Fig. 8) alternatively connected to one another by eight arcuate arch end-portions 101, whereby defining a single closed-loop arch 102 extending in a meandering manner over the entire circumference of the sputtering face 90a.

The upper edge of the tubular support 94 is besides provided with an annular toothed rack 103 cooperating with a pinion 104 adequately connected to the shaft of an external motor 105, which motor 105 is designed for slowly rotating the magnet assembly 95 according to a to-and-fro oscillatory movement, of an amplitude sufficient (about ±25°) for enabling the single closed-loop arch 102 generated by said magnet assembly 95 to be periodically scanned over the entire surface of the sputtering face 90a.

The tight chamber 87 containing the magnet assembly 95 is furthermore provided with a plurality of admission conduits 106 adequately extending through the insulating ring 81 and the baseplate 2 (while being electrically insulated from this baseplate 2) as well as with a plurality of evacuation conduits 107 adequately extending through the insulating ring 83 and the cover 82 (while being electrically insulated from this cover 82), so that a liquid coolant such as cold water can be continuously introduced through the admission conduits 106 for being freely circulated along the longitudinal spaces 49, delimitated between adjacent magnets of the magnet assembly 95, before being evacuated through the evacuation conduits 107.

Inside the sealed enclosure 3 is finally disposed a cylindrical substrate 109 to be externally coated, which centrally extends along the axis of the enclosure 3. This substrate 109 is mounted by its upper end against a discoidal member 110, which closes (via an insulating ring 111) a central opening 112 provided in the plane cover 82. In the interspace between the central cylindrical substrate 109 and the tubular sputtering target 90 is furthermore disposed a plurality of equiangularly spaced metal rods 113, which are connected by their upper ends against the internal face of the plane cover 82. The baseplate 2 and the cover 82 are connected to ground, while the hollow cathode 90 is connected via a switch 60 to the negative pole of a high voltage source 62 whose other pole is also grounded (the rods 113 electrically connected to the cover 82 being intended to play the role of anodes, while the substrate 109 electrically isolated from this cover 82 may have a "floating" potential).

The operation of the above-described apparatus is in many respects similar to that previously described:

The sealed enclosure 3 being provided with an atmosphere of argon of the order of $10^{-4}$ to $10^{-2}$ torr (of the order of $10^{-2}$ to 1 Pa), the liquid coolant is then circulated inside the tight chamber 87, while a negative high voltage is applied to the hollow cathode 90 (by closing the switch 60). The application of this negative high voltage leads to the formation of a single closed-loop intense plasma confined within the single meandering magnetic arch 102, whereby causing an intense sputtering of the target 90, and therefore a high-rate coating of the central substrate 109. Such a coating is proved to be carried out with an excellent uniformity, thanks to the periodical scanning of the single meandering plasma over the entire surface of the sputtering target 90, combined with an excellent stability of this single meandering plasma. The proper cooling of the target is besides ensured throughout said coating thanks to the free circulation of the liquid coolant along the longitudinal spaces 49 delimitated between adjacent magnets of the magnet assembly 95 (which longitudinal spaces 49 extend in front of the portions of the target 90 where the sputtering, and thus the heating up, is the more intense).

According to one variation of the embodiment of Figs. 6 to 8 the motor 105 for moving the magnet assembly 95 may be designed for rotating this assembly 95 according to a unidirectional rotatory movement instead of the to-and-fro rotatory movement previously described, so as to cause full revolutions of this magnet assembly 95 with respect to the tubular target 90 and the central substrate 109, whereby resulting in effects similar to that previously described as regards the good uniformity of target sputtering and substrate coating (which good uniformity of substrate coating may be still improved by further envisaging of equally rotating said central substrate 109).

Although the present invention has been specifically disclosed with preferred embodiments and drawings, variations of the concepts herein disclosed may be resorted to by those skilled in the art and such variations are considered to be within the scope of the invention and appended claims.

**Claims**

1. A cylindrical magnetron sputtering cathode comprising a tubular target having a face of material to be sputtered, a magnet assembly disposed behind the back face of said tubular target opposed to said sputtering face for generating magnetic fields having flux lines which project in a curve from said sputtering face and return thereto to form arch portions thereover, said magnet assembly consisting of a plurality of equiangularly spaced axially extending radially magnetized magnets arranged in such a manner as their flux lines form over said sputtering face a plurality of equiangularly spaced axially extending straight arch portions connected to each other by arcuate arch end-portions, wherein said plurality of magnets is arranged at both ends so as to form arcuate arch end-portions connected in an alternate manner to said straight arch portions, whereby defining a single closed-loop arch extending in a meandering manner over the entire circumference of said sputtering target, closure means for delimitating in combination with the back face of said tubular target a cylindrical tight chamber enclosing at least partially said magnet assembly, and means for axially circulating a liquid coolant within said tight chamber, whereby said liquid coolant can freely flow from one to the other end of said chamber, along the longitudinal spaces delimitated between adjacent magnets of said plurality of equiangularly spaced axially extending magnets.

2. The cylindrical magnetron sputtering cathode of Claim 1, further comprising means for axially rotating said magnet assembly and said tubular target relatively to each other, so as to cause a substantially uniform target sputtering.

3. The cylindrical magnetron sputtering cathode of Claim 1, wherein said plurality of magnets comprises a first group of equiangularly spaced axially extending main magnets, in even numbers and with alternate polarity, for generating said equiangularly spaced axially extending straight arch portions, said first group being completed by a second group of end-magnets adequately arranged in the prolongation of both ends of the main magnets of said first group, for generating said arcuate arch end-portions connecting said straight arch portions.

4. The cylindrical magnetron sputtering cathode of Claim 1, further comprising a tubular intermediate support inserted between said tubular target and said magnet assembly, said tubular intermediate support therefore forming part of the wall of said tight chamber for enclosing said magnet assembly.

5. The cylindrical magnetron sputtering cathode of Claim 4, wherein said tubular target is arranged in close contact against said tubular intermediate support.

**Revendications**

1. Cathode de pulvérisation cylindrique à magnétron comprenant une cible tubulaire présentant une face d'un matériau à pulvériser, un ensemble d'aimants disposé au dos de la face arrière de cette cible tubulaire opposée à ladite face de pulvérisation pour produire des champs magnétiques présentant des lignes de flux qui font saillie en une courbe depuis cette face de pulvérisation et reviennent à celles-ci pour former des portions d'arceau sur elle, cet ensemble d'aimants comprenant une pluralité d'aimants aimantés radialement s'étendant axialement espacés équiangulairement, agencés de telle manière que leurs lignes de flux forment sur ladite face de pulvérisation une pluralité de portions d'arceau droites s'étendant axialement, espacées équiangulairement reliées l'une à l'autre par des portions d'extrémité d'arceau arquées, dans laquelle cette pluralité d'aimants est agencée à deux extrémités de manière à former des portions d'extrémité d'arceau arquées connectées de manière alternative auxdites portions d'arceau droites, de manière à définir un seul arceau à boucle fermée s'étendant en un méandre sur toute la circonférence de cette cible de pulvérisation, des moyens de fermeture pour délimiter, en combinaison avec la face arrière de cette cible tubulaire, une chambre cylindrique étanche renfermant au moins partiellement ledit ensemble d'aimants et des moyens pour faire circuler axialement un réfrigérant liquide dans cette chambre étanche, de sorte que ce réfrigérant liquide puisse s'écouler librement de l'une à l'autre extrémité de cette chamber, le long des espaces longitudinaux délimités entre des aimants adjacents de cette pluralité d'aimants s'étendant axialement espacée équiangulairement.

2. Cathode de pulvérisation cylindre à magnétron selon la revendication 1, comprenant en outre des moyens pour faire tourner axialement cet ensemble d'aimants et ladite cible tubulaire relativement l'un à l'autre, de manière à provoquer une pulvérisation de cible sensiblement uniforme.

3. Cathode de pulvérisation cylindrique à magnétron selon la revendication 1, caractérisée en ce que ladite pluralité d'aimants comporte un premier groupe d'aimants principaux s'étendant axialement, espacés équiangulairement, en nombre pair et avec une polarité alternée, pour engendrer lesdites portions d'arceau droites s'étendant axialement, espacées équiangulairement, ce premier groupe étant complété par un second groupe d'aimants d'extrémité agencés de façon adéquate dans le prolongement des deux extrémités des aimants principaux dudit premier groupe pour engendrer lesdites portions d'extrémité d'arceau arquées reliant lesdites portions d'arceau droites.

4. Cathode de pulvérisation cylindrique à magnétron selon la revendicaton 1, comprenant en outre un support intermédiaire tubulaire inséré entre ladite cible tubulaire et ledit ensemble d'aimants, ce support intermédiaire tubulaire faisant par conséquent partie de la paroi de ladite chambre étanche renfermant ledit ensemble d'aimants.

5. Cathode de pulvérisation cylindrique à magnétron selon la revendication 4, caractérisée en ce que ladite cible tubulaire est agencée en contact étroit contre ledit support intermédiaire tubulaire.

**Patentansprüche**

1. Zylindrische Magnetron-Zerstäuberkathode, die ein eine zu zerstäubende Materialfläche aufweisendes rohrförmiges Target, eine Magnetanordnung hinter der Rückfläche des rohrförmigen Targets, der Zerstäuberfläche gegenüberliegend, zur Erzeugung von Magnetfeldern mit Flußlinien, die in einer Kurve von der Zerstäuberfläche ausgehen und zu dieser zurückkehren, um über dieser Bogenabschnitte zu bilden, wobei die Magnetanordnung aus mehreren, in gleichen Winkeln getrennten, axial sich erstreckenden, radial magnetisierten Magneten besteht, die derart angeordnet sind, daß ihre Flußlinien über der Zerstäuberfläche eine Vielzahl unter gleichen Winkeln getrennter, axial sich erstreckender, gerader Bogenabschnitte bilden, die miteinander durch gebogene Bogenendabschnitte verbunden sind, wobei die Vielzahl an Magneten an beiden Enden so angeordnet ist, daß bogenförmige Bogenendabschnitte gebildet sind, die abwechselnd mit den geraden Bogenabschnitten verbunden sind, wodurch ein einziger Bogen mit geschlossener Schleife festgelegt ist, der in Mäanderform sich über den gesamten Umfang des Zerstäubertargets erstreckt, Abdeckeinrichtungen zur Begrenzung, in Kombination mit der Rückfläche des rohrförmigen Targets, einer zylindrischen, dichten Kammer, die wenigstens teilweise die Magnetanordnung umschließt, und Einrichtungen umfaßt, um ein flüssiges Kühlmittel innerhalb der dichten Kammer axial umlaufen zu lassen, wobei das flüssige Kühlmittel frei von einem zum anderen Ende der Kammer entlang der zwischen benachbarten Magneten der Vielzahl von unter gleichen Winkeln getrennten, axial sich erstreckenden Magneten begrenzten Längsräumen fließen kann.

2. Zylindrische Magnetron-Zerstäuberkathode nach Anspruch 1, die weiters Einrichtungen zur axialen Verdrehung der Magnetanordnung und des rohrförmigen Targets relativ zueinander aufweist, um so eine im wesentlichen gleichmäßige Targetzerstäubung hervorzurufen.

3. Zylindrische Magnetron-Zerstäuberkathode nach Anspruch 1, bei der die Vielzahl der Magnete eine erste Gruppe unter gleichen Winkeln getrennter, axial sich erstreckender Hauptmagnete aufweist, und zwar in gerader Anzahl und mit abwechselnder Polarität, um die unter gleichem Winkel getrennten, axial sich erstreckenden, geraden Bogenabschnitte zu bilden, wobei die erste Gruppe durch eine zweite Gruppe von Endmagneten vervollständigt ist, die entsprechend in der Verlängerung beider Enden der Hauptmagnete der ersten Gruppe angeordnet sind, um die bogenförmigen Bogenendabschnitte zu erzeugen, die die geraden Bogenabschnitte verbinden.

4. Zylindrische Magnetron-Zerstäuberkathode nach Anspruch 1, die weiters einen rohrförmigen Zwischenträger aufweist, der zwischen das rohrförmige Target und der Magnetanordnung eingebracht ist, so daß der rohrförmige Zwischenträger daher Teil der Wand der dichten Kammer zum Umschließen der Magnetanordnung bildet.

5. Zylindrische Magnetron-Zerstäuberkathode nach Anspruch 4, bei der das rohrförmige Target in engem Kontakt mit dem rohrförmigen Zwischenträger angeordnet ist.

FIG. 1

FIG. 2

FIG. 3

FIG. 4

FIG. 5

FIG. 8

FIG. 6

FIG. 7